# EUROPEAN PATENT SPECIFICATION

(11) **EP 0 299 465 B1**
(45) Date of publication and mention of the grant of the patent: **29.09.1993**
(21) Application number: 88111265.0
(22) Date of filing: 13.07.1988
(51) Int. Cl.: G01R 13/34, G04F 13/02

(54) **An apparatus for sampling, analyzing and displaying an electrical signal**
Einrichtung zum Abtasten, Analysieren und Anzeigen eines elektrischen Signals
Appareil pour l'échantillonnage l'analyse et l'affichage d'un signal électrique

(30) Priority: 14.07.1987 JP 175509/87; 14.07.1987 JP 175510/87
(43) Date of publication of application: 18.01.1989
(73) Proprietor: HAMAMATSU PHOTONICS K.K., Shizuoka-ken (JP)
(72) Inventor: Takiguchi, Yoshihiro, Hamamatsu-shi Shizuoka (JP)
(74) Representative: Grünecker, Kinkeldey, Stockmair & Schwanhäusser Anwaltssozietät

(56) References cited:
- IEEE JOURNAL OF QUANTUM ELECTRONICS, vol. QE-20, No. 12, December 1984, pages 1516-1528, New York US; Y. TSUCHIYA "Advances in Streak Camera Instrumentation for the Study of Biological and Physical Processes"
- APPLIED PHYSICS LETTERS, vol 49, no. 6, 11 August 1986, pages 357-359, New York US; R.B. Marcus et al.: "High-Speed electrical sampling by fs photoemission"
- JOURNAL OF PHYSICS E/SCIENTIFIC INSTRUMENTS, vol. 21, no. 7, July 1988, pages 701-704, Bristol GB, G. Shen et al.: "A versatile optical multichannel analyser system for use with picosecond streak cameras"

## Description

This invention relates to a photoelectron sampling apparatus in accordance with claim 1.

There have been methods of observing high speed phenomeina in which a high speed repetitive signal is sampled at a predetermined interval to step down to a predetermined frequency. For example, in one method a sampling pentode utilizing a thermal electron source for analyzing electrical signals is provided, where the grid of the pentode is normally biased to the cutoff region and a current flows when a negative sampling pulse is applied to the cathode. In another method, diodes are arranged to form a mixer circuit and when a sampling pulse is applied to the mixer circuit, a signal current flows due to diode characteristics. In still another method, an electro-optical crystal is used and sampling is effected on the basis of ON/OFF characteristics of the crystal.

However, all of the foregoing methods suffer performance inhibiting disadvantages. In particular, the sampling pentode method utilizing the thermal electron source exhibits poor frequency response to the sampling signal in view of the thermal electron source. The method utilizing the diodes arranged to form the mixer circuit responds to sampling signals of only about 20 ps due to limitations of the diode response characteristics, and also experiences a large amount of jitter. Further, the method utilizing the electro-optical crystal lacks reliability since the crystal is sensitive to temperature and humidity changes. In addition, none of the conventional methods are capable of reading out the waveform of an electrical signal in two dimensions.

A high-speed electrical sampling apparatus is also known from document APPLIED PHYSICS LETTERS, Vol.49 No.6, 8.86, p. 357-359, in that it describes a method for contactless sampling of high-speed electrical signals, whereby a laser provides fs pulses. A first beam is admitted into a vacuum chamber and is focused by a lens on a gold sample. A signal to be measured is also induced to the sample. A planar copper anode mounted above the sample surface functions as a detector and a DC-biased wire screen below the anode provides an extraction field.

In time resolved experiments electrical plulses are generated by focusing a second beam from the laser onto a high-speed photodetector that is connected with the sample and is located outside the vacuum chamber.

An object of the present invention is a photoelectron sampling apparatus that overcomes the foregoing problems and disadvantages of prior sampling devices.

A further object of the present invention is a photoelectron sampling apparatus having a good SN ratio.

Another object of the present invention is a photoelectron sampling apparatus for analyzing and displaying an electrical signal having high resolution.

These objects are solved by the features of the characterizing clause of claim 1.

With a photoelectron sampling apparatus according to the present invention, photoelectron pulses ranging in duration from femtoseconds to picoseconds produced when a light pulse of similar duration is incident upon a photocathode, are modulated by an electrical signal to be measured which is applied to a signal electrode. This modulated signal is used to provide the sampled waveform of the electrical signal to be measured. Further, two-dimensional picture information is obtained for every displacement by deflecting the waveform sampled in accordance with the time difference between the sampling signal and the signal to be measured. The waveform of the electrical signal is then converted into a two-dimensional picture image for analyzing and processing.

The manner by which the above objects and other objects, features, and advantages of the present invention are attained will be fully apparent from the following detailed description when it is considered in view of the drawings, wherein:
Fig. 1 is a block diagram showing an embodiment of a photoelectron sampling apparatus according to the present invention;
Fig. 2 is a block diagram showing another embodiment of a photoelectron sampling apparatus according to the present invention;
Fig. 3 is a diagram showing an arrangement of a photoelectron sampling tube used in the present invention;
Fig. 4 is a diagram showing an example of voltages applied to the photoelectron sampling tube shown in Fig. 3;
Fig. 5 is a diagram showing a photoelectron sampling tube of a proximate type which requires no focus electrodes;
Fig. 6 is a diagram showing an embodiment of an apparatus for analyzing and displaying an electrical signal according to the present invention;
Fig. 7 is a diagram showing another embodiment of an apparatus for analyzing and displaying an electrical signal according to the present invention;
Fig. 8 is a diagram showing an arrangement of an electrical signal displaying unit;
Fig. 9 is a diagram showing another embodiment of an electrical signal displaying unit in which an image information is read out through a semiconductor image device;
Fig. 10 is a diagram showing an output image when the waveform is deflected in only one direction by the voltage proportional to the delay time;
Fig. 11 is a diagram showing an output image when the delay time is given as a logarithmic function; and
Fig. 12 is a diagram showing timing waveforms in an apparatus for analyzing and displaying an electrical signal according to the present invention.

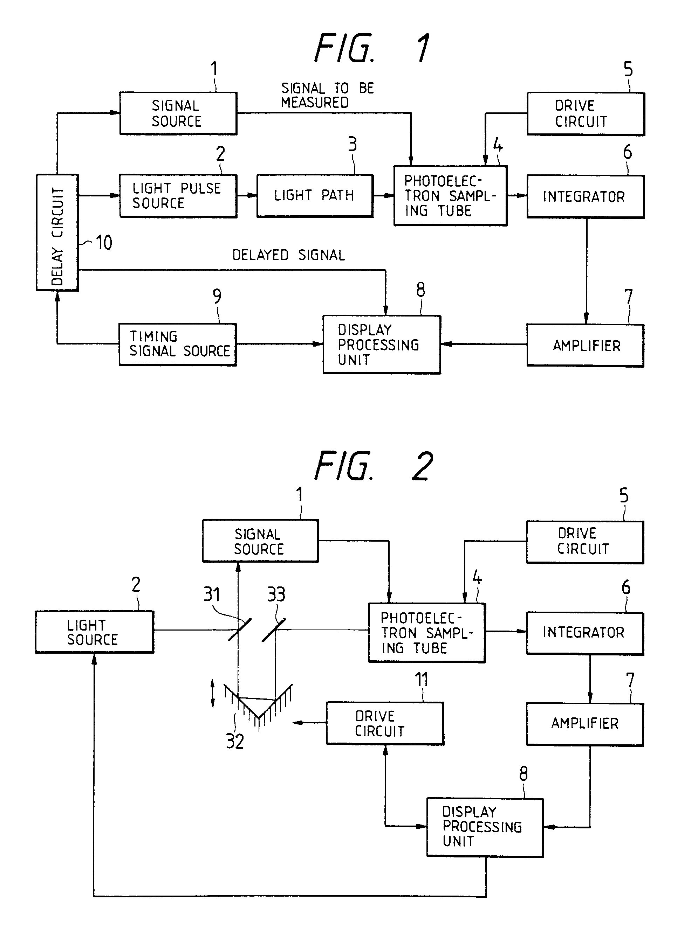

Fig. 1 is a block diagram showing an arrangement of a photoelectron sampling apparatus according to the present invention. In Fig. 1, reference numeral 1 designates a signal source generating a signal to be measured; 2, a light pulse source; 3, a light transmission path; 4, a photoelectron sampling tube; 5, a drive circuit; 6, an integrator; 7, an amplifier; 8, a display processing unit; 9, a timing signal source; and 10, a delay circuit.

In Fig. 1, the light pulse source 2 is, for example, a laser that is synchronized with the signal source 1 by means of a timing signal from the signal source 1. Timing of the generation of the light pulse and the signal to be measured is delayed optically or electrically by the delay circuit 10, which may be varied at will.

The light pulse from the light pulse source 2 is incident upon the photoelectron sampling tube 4 through the light transmission path 3 to generate a photoelectron pulse. The photoelectron pulse is intensity modulated by the signal to be measured. This modulated photoelectron pulse is then multiplied in the sampling tube, integrated by the integrator 6, and amplified by the amplifier 7. In the above embodiment, the time difference between the photoelectron pulse and the signal to be measured, or the phase in which the photoelectron pulse is intensity modulated by the signal to be measured (sampling phase), is varied to reproduce, at the display processing, unit 8, the waveform of the signal to be measured as a function of this time difference.

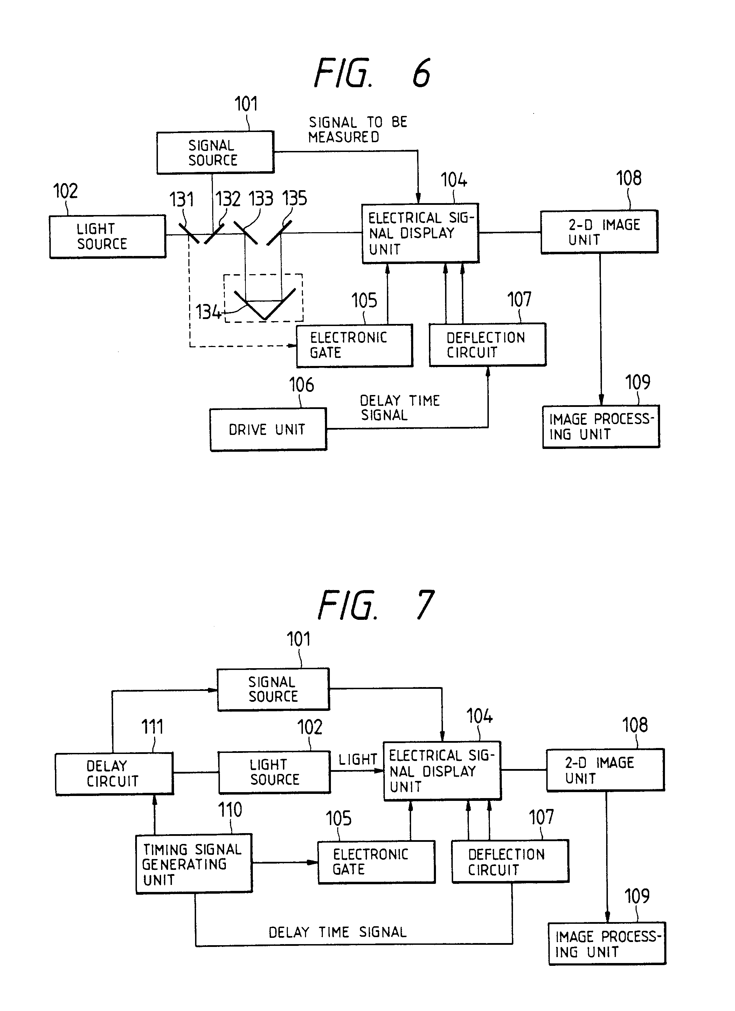

Fig. 2 is a block diagram showing another embodiment of a photoelectron sampling apparatus according to the present invention. In Fig. 2, reference numeral 11 is a drive circuit, 31 is a half mirror, and 32 and 33 are reflectors, with the remaining like reference numerals identifying like components in Fig. 1. In this embodiment, the light pulse source 2 generates a light pulse upon receiving a trigger signal from the display processing unit 8, and the light pulse triggers the source 1 of the signal to be measured in order to synchronize the occurrence of the light pulse, the signal to be measured, and the display processing apparatus. Also, the light pulse incident upon the photoelectron sampling tube 4, is delayed by the optical delay elements formed of the half mirror 31 and the reflectors 32 and 33. The amount of delay can be varied by varying the light transmission length, which is effected by displacing the reflector 32 using the drive circuit 11. At the same time, the signal from the driven circuit 11 is applied to the display processing unit 8 to express, as a function, the timing of occurrence of the signal to be measured and the photoelectron pulse, thereby reproducing the waveform of the signal to be measured. Details of this process will be explained with respect to the embodiment of the present invention shown for example in Figs. 6-12.

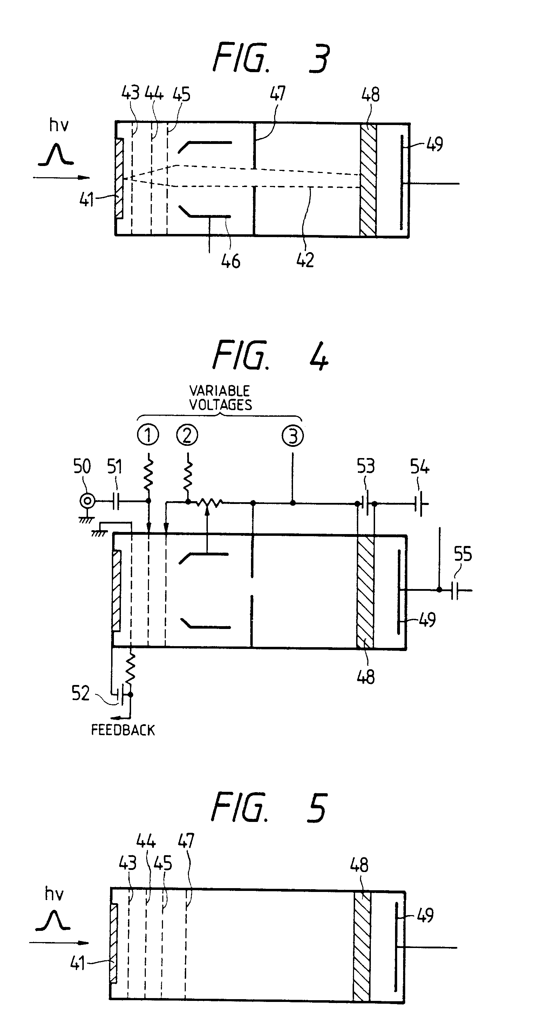

Fig. 3 is a diagram showing an arrangement of a photoelectron sampling tube used in the present invention, Fig. 4 is a diagram showing an example of voltages applied thereto, and Fig. 5 is a diagram showing an arrangement of a photoelectron sampling tube which needs no focus electrodes. In Figs. 3, 4 and 5, reference numeral 41 refers to a photocathode; 42, a photoelectron beam; 43, a first acceleration electrode; 44, a signal electrode; 45, a bias electrode; 46, a focus electrode; 47, a second acceleration electrode; 48, a micro-channel plate; 49, an anode; 50, a high frequency connector; 51 and 55 capacitors; and 52, 53 and 54, power supplies. The electrodes 43, 44 and 45 may be of a strip line configuration.

In the photoelectron sampling tube shown in Figs. 3, 4, and 5, when a short light pulse ranging in duration from femtoseconds to picoseconds is incident upon the photocathode 41 from a laser source (not shown), and a voltage is applied between the photocathode 41 and the first acceleration electrode 43, photoelectron pulses ranging in duration from femtoseconds to picoseconds are extracted from the photocathode 41. In this case, reducing the surface area of the photocathode 41 can present degradation of the SN ratio due to thermal noise. Also, since the pulse duration of the extracted photoelectrons is determined by the electric field strength across the photocathode and the first acceleration electrode, the electric field should be increased to obtain the short photoelectron pulses. For this purpose, the potential of the first acceleration electrode 43 may be set sufficiently high with respect to the potential of the photocathode 41, and/or the distance between the photocathode 41 and the first acceleration electrode 43 may be shortened. If the potential of the first acceleration electrode 43 is to be set high, the power supply 52 may be connected such that the first acceleration electrode 43 is grounded and the photocathode 41 is negative as shown in Fig. 4, thereby preventing return of photoelectrons to the photocathode 41 to assure effective operation.

The photoelectron pulse 42 thus accelerated is modulated by the voltage across the signal electrode 44 and the bias electrode 45. The signal electrode 44 is required to have adequate high frequency characteristics; therefore it is necessary to form the signal electrode 44 of a strip line, while at the same time the distance between the source of the signal to be measured (not shown) and the signal electrode 44 should be as short as possible to prevent distortion of the signal to be measured. The photoelectron pulse 42 is thus modulated by the signal to be measured, and is then accelerated by the focus electrode 46 and the second acceleration electrode 47, which can be adjusted by varying the voltages applied thereto, so as to control the trajectory of the photoelectron pulse 42. The photoelectron pulse 42 is then multiplied by the micro-channel plate 48 to obtain an output from the anode 49. In this case, a pentode is formed by the first acceleration electrode 43, the signal electrode 44, the bias electrode 45, the micro-channel plate 48, and the anode 49; and modulation by the voltage of the signal electrode 44 is directly obtained from the anode 49. The signal thus obtained may then be displayed on a display unit such as a CRT for further analysis.

It should be apparent from the foregoing description that a dynode may be used for multiplication of the photoelectron pulse instead of the micro-channel plate 48. Further, while a short pulse YAG laser, dye laser, or a semiconductor laser may be used as the laser light source, an infrared light is preferably used in order to minimize initial velocity energy distribution of photoelectrons. Furthermore, an optical fiber (not shown) may be provided between the laser light source 2 and the photocathode surface 41 to reduce optical loss in transmitting the light pulse.

The detected photoelectron current can be fed back from the first acceleration electrode 43 to the laser light source 2 to promote generation of a constant photoelectron beam. Additionally, a CPU may be used to control the photocathode, the voltage of the acceleration electrodes, the voltage of the electron-multiplying section, the anode voltage, the timing difference between the photoelectron pulse and the signal to be measured, the integration time of the modulated electrical signal from the anode electrode, and the amplification factor of the integrated signal, to provide an automated measurement.

Fig. 6 is a block diagram showing an arrangement of an embodiment of an apparatus for analyzing and displaying an electrical signal according to the present invention. In Fig. 6, reference numeral 101 represents a signal source generating a signal to be measured; 102, a laser light source; 131 and 132, half mirrors, 133, 134, and 135, reflectors; 104, an electrical signal displaying unit; 105, an electronic gate; 106, a drive unit; 107, a deflection circuit; 108, a two-dimensional image unit; and 109, an image information processing unit.

In Fig. 6, the laser light source 102 generates a light pulse, which triggers the signal source 101 through the half mirrors 131 and 132 to generate the signal to be measured in synchronism with the light pulse, while also triggering the electronic gate 105 through the half mirror 131 to turn on the electrical signal displaying unit 104. The light pulse is optically delayed by passing it through the reflectors 133, 134 and 135, and is then incident upon the electrical signal displaying unit 104. The amount of delay can be varied by displacing the reflector 134 by means of the drive unit 106, and the deflection voltage, in accordance with the amount of delay, is applied by means of the deflection circuit 107 to the electrical signal displaying unit 104. Although, as described above, the input light pulse to the electrical signal displaying unit 104 is delayed with respect to the signal to be measured, the signal to be measured may instead by delayed with respect to the light pulse to provide the same result.

In this embodiment, the pulse light from the laser light source 102 is delayed optically and is then incident upon the electrical signal display unit 104 to generate a photoelectron pulse while also activating the signal source 101 to provide synchronous operation of the two. The photoelectron pulse is generated, upon incidence of the light pulse, in the electrical signal displaying unit 104 with a predetermined delay time between the signal to be measured and is intensity modulated by the signal to be measured. The modulated photoelectron pulse is then deflected by a deflection voltage (described below) in accordance with the time difference or delay time between the signal to be measured and the photoelectron pulse to provide a display output. In this manner, the photoelectron pulse is modulated by an electrical signal to convert the electrical signal into a two-dimensional image for display. The electrical signal thus converted into the two-dimensional image is output to the two-dimensional image unit 108, and is further processed as two-dimensional image information in the image information processing unit 109. Additionally, the electronic gate 105 is provided to decrease the noise from the photocathode.

Fig. 7 is a diagram showing another embodiment of an apparatus for analyzing and for displaying an electrical signal according to the present invention. Like reference numerals refer to like components shown in Fig. 6, and reference numeral 110 designates a timing signal generating unit and 111 a delay circuit.

In this embodiment, the timing signal from the timing signal generating unit 110 is applied through the delay circuit 111 to the laser light source 102 and the signal source 101 so as to trigger both of them. In addition, the electronic gate 105 and the deflection circuit 107 are directly activated by the timing signal. The rest of the arrangement and operation is similar to that in Fig. 6.

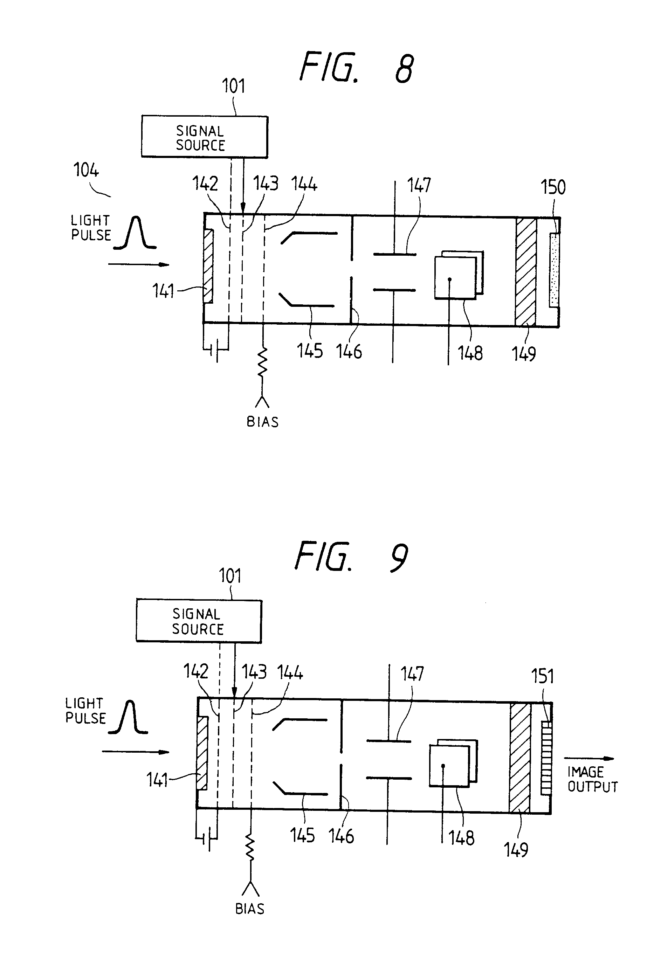

Fig. 8 is a diagram showing an arrangement of an embodiment of an electrical signal display unit 104 which is similar in some respects to the photoelectron sampling tubes shown in Figs. 3-5. In Fig. 8, reference numeral 141 is a photocathode; 142, a first acceleration electrode; 143, a signal electrode; 144, a bias electrode; 145, a focus electrode; 146, a second acceleration electrode; 147 and 148, deflection electrodes; 149, a two-dimensional electron multiplier; and 150, a phospher screen. The photoelectron pulse is extracted from the photocathode 141 due to incidence of the light pulse thereon and is accelerated by the first acceleration electrode 142 before being modulated by the signal to be measured at the signal electrode 143. The modulation may be effected, for example by performing a triode operation between the bias electrode 144. The electronic gate shown in Fig. 6 is implemented by varying the bias to control conduction of the triode. After the photoelectron pulse is modulated, it is accelerated toward the phospher screen 150 by the focus electrode 145 and the second acceleration electrode 146. Additionally, deflection electrodes 147 and/or 148 may be driven to deflect the photoelectron pulse as necessary. After being deflected, the photoelectron pulse is multiplied by the two-dimensional electron multiplier 149 for example a micro-channel plate, and is then converted into a light image at the phospher screen 150.

As with the embodiments shown in Fig. 1-7, use of a laser light pulse, ranging from induration from femtoseconds to picoseconds, permits analysis of the waveform of an electrical signal ranging from THz to GHz. In this case, it may be necessary to narrow the spacing between the first acceleration electrode 142 and the photocathode 141, since, as described above, a photoelectron pulse having a short period is generated by increasing the electric field between the photocathode 141 and the first acceleration electrode 142.

Fig. 9 shows another embodiment of the electrical signal display unit 104 in which the image information multiplied by the two-dimensional electron multiplier 149, is read out through a semiconductor image device 151 as a displayed image.

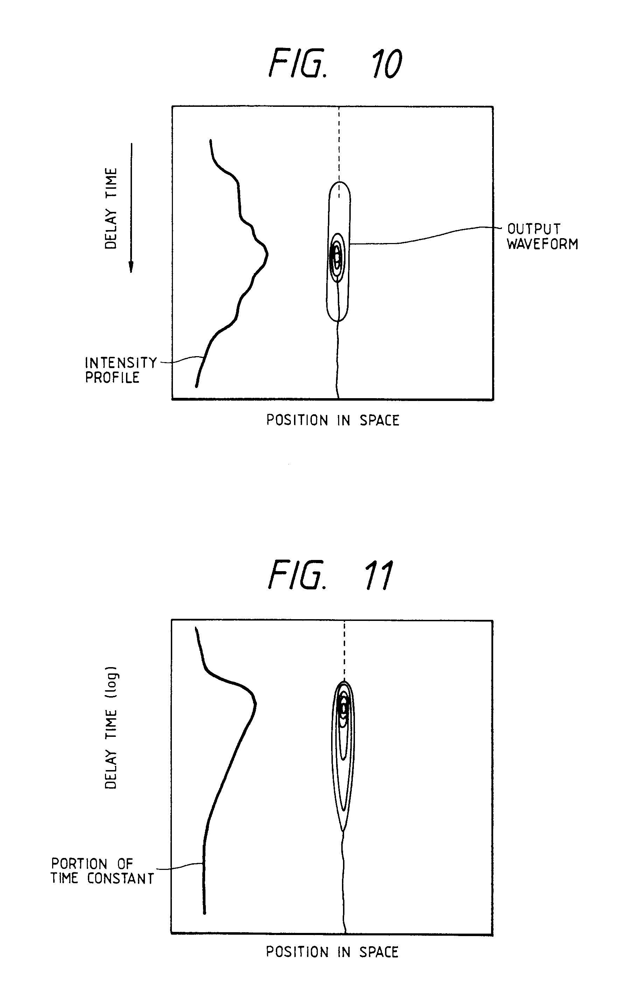

Fig. 10 shows an example of an output from an electrical signal display unit 104 as shown in Figs. 8 and 9 for analyzing and displaying the electrical signal. Specifically, Fig. 10 shows an example of an output waveform when the output is deflected in only one direction by the voltage varying in proportion to the delay time. The ordinate shows the difference of the delay time between the signal to be measured and the photoelectron pulse (the sampling phase) and the abscissa shows the position in space. The intensity distribution at any location is shown by the dotted line and the profile of the dotted line corresponds directly to the waveform of the electrical signal.

In addition, deflecting in two directions permits a display of a multi-sampling image at spatially different positions, respectively.

Fig. 11 shows an output when the delay time is given as a logarithmic function in which the portion decaying exponentially appears to be a straight line. It is during this straight line portion that the time constant and others are directly obtained.

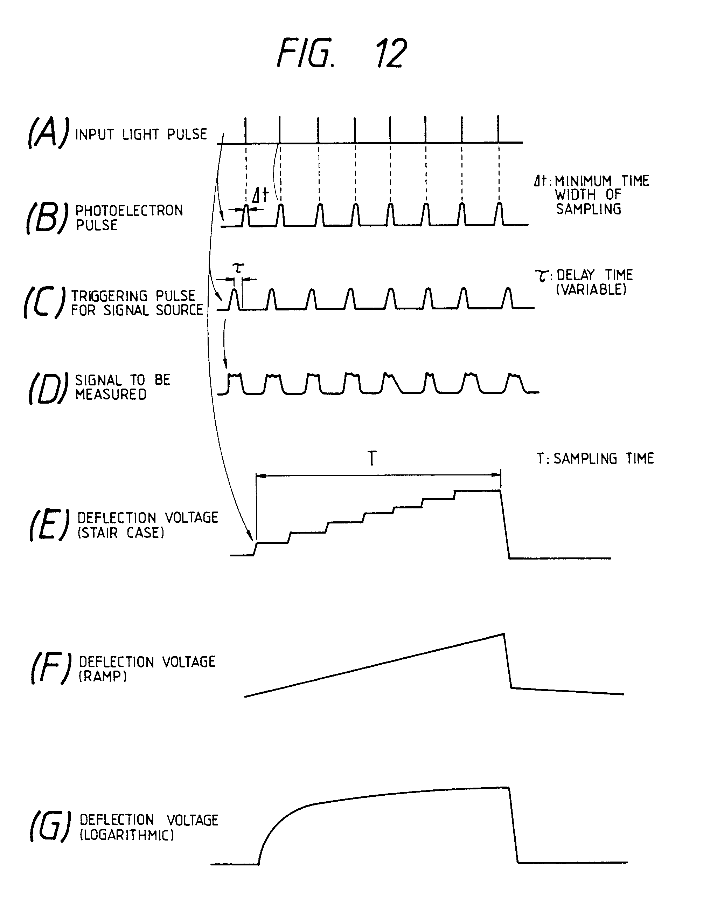

Fig. 12 shows timing waveforms in an apparatus for analyzing and displaying an electrical signal according to the present invention, in which the photoelectron pulse shown at Fig. 12 (B) is generated in synchronism with the input light pulse shown in Fig. 12 (A). In this case, the width, Δt of the photoelectron pulse given a minimum time period, however, the image display will be much better if the peak value of the photoelectron pulse is detected. The delay time τ between the photoelectron pulse and the pulse for triggering the signal to be measured, is scanned with respect to time by a variable delay circuit (Fig. 12 (C)). This trigger pulse causes the signal to be measured to occur (Fig. 12 (D)), and the photoelectron pulse is intensity modulated based on the signal to be measured. At this time, since the phase relation between the signal to be measured and the photoelectron pulse varies in accordance with the delay time τ, the sampling phase with respect to the signal to be measured can be varied. The waveform of the signal to be measured can be reproduced in any desired form by effecting deflection with any of the deflection voltages shown in Fig. 12 (E) to (G) corresponding to the varied delay time. It will be recognized that deflection voltages can be of various other forms such as a sinusoidal voltage or an exponential voltage.

The delay time τ should be permitted to vary within a range that allows the waveform of the pulse to be measured and sufficiently analyzed. This variation range may be, for example 1/100 or 1% of the width of the signal to be measured.

Additionally, although the above embodiment is arranged in such a way that a sampling electron is obtained from the photoelectron pulse incident upon the photocathode, those of ordinary skill will recognize that a thermal electron source that is produced electrically can also be applied to convert the electrical signal into a two-dimensional image.

Thus, in accordance with the present invention, since the electrical signal to be measured is sampled by the two-dimensional photoelectron pulse, outputting the electrical signal as a two-dimensional image is made possible. Further, generation of the photoelectron pulse using the laser light pulse enables analysis of electrical signal waveforms ranging in frequency from THz to GHz, in which case, resolution of the analysis is dependent on the pulse width of the photoelectron pulse or the pulse width of the incident light. Since the electrical signal waveform of such a high frequency in a range of picoseconds to femtoseconds can be output in the form of an image, the distortion can be greatly reduced as compared to the distortion according to conventional sampling methods. The waveform can be directly analyzed due to the fact that the deflection voltage can be applied in an arbitrary form, which reduces loads imposed on the subsequent processing systems while also providing a high electron multiplying gain (10³ to 10⁵) with a high SN ration, thereby reducing loads imposed on the reading circuits.

## Claims

1. A photoelectron sampling apparatus, comprising a light pulse source (2,102), a photocathode (41,141) for receiving a light pulse emitted by said light pulse source (2,102), a bias electrode (45) and detection means (49,150,151) for collecting the photoelectron pulse
**characterized by**
a signal electrode (44,143) for receiving a signal to be measured and for modulating the accelerated photoelectron pulse using said signal to be measured, and
an acceleration electrode (43,142,146,47) for accelerating a photoelectron pulse emitted by said photocathode (41,141) after receiving said light pulse.

2. A photoeclectron sampling apparatus according to claim 1, wherein said detection means (49,150,151) for collecting the photoelectron pulse is an electrode.

3. A photoelectron sampling apparatus according to claim 1, wherein said light pulse source (2,102) is a laser light source for outputting a laser light pulse.

4. A photoelectron sampling apparatus according to claim 1, wherein a distance between said photocathode (41,141) and said acceleration electrode is set short.

5. A photoelectron sampling apparatus according to claim 1, wherein a potential of said acceleration electrode (43,142,146,47) is set sufficiently high with respect to a potential of said photocathode (41,141) to provide a photoelectron pulse having a period ranging in duration from femtoseconds to picoseconds.

6. A photoelectron sampling apparatus according to claim 1, further comprising a micro-channel plate (48) multiplying the modulated photoelectron pulse before being collected by said detection means (49).

7. A photoelectron sampling apparatus according to claim 1, further comprising a dynode plate for multiplying the modulated photoelectron pulse before being collected by said detection means.

8. A photoelectron sampling apparatus according to claim 1, wherein said signal electrode (44,143) is a strip line electrode.

9. A photoelectron sampling apparatus according to claim 3, further comprising means for feeding a detected signal of a photoelectron current existing between said electro-optical surface and said acceleration electrode (43,142,146,47) back to said laser light source to control said laser light source (2,102).

10. A photoelectron sampling apparatus according to claim 3, further comprising means for triggering said signal source (1,101) to generate said signal to be measured and for triggering said laser light source (2,102) to output said laser light pulse.

11. A photoelectron sampling apparatus according to claim 3, further comprising means responsive to said laser light pulse for triggering said signal source (1,101) to generate said signal to be measured.

12. A photoelectron sampling apparatus according to claim 3, further comprising a delay circuit (10,111,32,130) for each of said light source (2,102) and said signal source (1,101) to delay the output of said laser light pulse and said signal to be measured as desired.

13. A photoelectron sampling apparatus according to claim 1,
**characterized by**
further comprising delay means (10,111,32,124) for producing a delay time difference between said photoelectron pulse and said signal to be measured;
deflection means (147,148) for deflecting said photoelectron pulse, in accordance with said delay time difference;
detection means (49,150,151) for displaying two-dimensional image information obtained for each displacement of said photoelectron pulse due to deflection by said deflection means; and
picture information processing means for processing and analyzing said two-dimensional image information.

14. A photoelectron sampling apparatus according to claim 13, further comprising a thermal electron source for generating said photoelectron pulse by the use of a voltage generated electrically.

15. A photoelectron sampling apparatus according to claim 13, wherein said signal to be measured is sampled by, modulating the intensity of said photoelectron pulse based on a voltage of said signal to be measured.

16. A photoelectron sampling apparatus according to claim 13, wherein said detection means (4,104) includes a phosphor secreen (150) for converting said two-dimensional image information into an optical image.

17. A photoelectron sampling apparatus according to claim 13, wherein said detection means (4,104,151) includes a semiconductor image device for converting said two-dimensional electron image information into an electrical image.

18. A photoelectron sampling apparatus according to claim 13, further comprising a first deflection electrode (148) for deflecting said photoelectron pulse in a horizontal direction and a second deflection electrode (147) for deflecting said photoelectron pulse in a vertical direction.

19. A photoelectron sampling apparatus according to claim 13, further comprising a first deflection electrode (147) for deflecting said photoelectron pulse in a vertical direction and a second deflection electrode (148) for deflecting said photoelectron pulse in a horizontal direction.

20. A photoelectron sampling apparatus according to claim 13, further comprising an electronic gate (105) for reducing noise from said photocathode.

21. A photoelectron sampling apparatus according to claim 18, wherein said deflection voltage which is applied to at least one of said horizontal and vertical deflection electrodes (147,148) is one of a sinusoidal waveform voltage, a ramp waveform voltage, a staircase waveform voltage, a logarithmic waveform voltage, and an exponential-function waveform voltage.

22. A photoelectron sampling apparatus according to claim 15, further comprising means for multiplying (149) said photoelectron pulse in two dimensions, after said photoelectron pulse is modulated and deflected.

23. A photoelectron sampling apparatus according to claim 1, further comprising display means for displaying, as a function, timing difference between said photoelectron pulse and said signal to be measured.

24. A photoelectron sampling apparatus according to claim 1, wherein a distance between a source of said signal (1,101) to be measured and said signal electrode (143,44) is set short.

25. A photoelectron sampling apparatus according to claim 3, wherein an optical fiber being small in optical loss and high in time-response is used for light transmission between said laser light source and said photocathode.

26. A photoelectron sampling apparatus according to claim 1, wherein the area of said photocathode (141,41) is made small.

27. A photoelectron sampling apparatus according to claim 1, wherein an infrared light source is used as said light pulse source so as to make initial velocity energy distribution of said photoelectron pulse narrower.

28. A photoelectron sampling apparatus according to claim 16, wherein said optical image is read out to be converted to an electrical signal, said electrical signal being processed in image processing means.

29. An apparatus for analyzing and displaying a sampled electrical signal according to claim 17, wherein said electrical signal is read out to be processed in image processing means.

## Patentansprüche

1. Photoelektronenmeßvorrichtung, die umfaßt: eine Lichtpulsquelle (2, 102), eine Photokathode (41, 141) zum Empfang eines von der Lichtquelle (2, 102) emittierten Lichtpulses, eine Vorspannungselektrode (45) und eine Detektionseinrichtung (49, 150, 151), um den Photoelektronenpuls aufzufangen,**gekennzeichnet durch** eine Signalelektrode (44, 143) zum Empfangen eines zu messenden Signals und zur Modulation des beschleunigten Photoelektronenpulses unter Verwendung des zu messenden Signals, und eine Beschleunigungselektrode (43, 142, 146, 47) um einen Photoelektronenpuls, der von der Photokathode (41, 141) nach Empfang des Lichtpulses emittiert wurde, zu beschleunigen.

2. Photoelektronenmeßvorrichtung gemäß Anspruch 1, wobei die Detektionseinrichtung (49, 150, 151) zum Auffangen des Photoelektronenpulses eine Elektrode ist.

3. Photoelektronenmeßvorrichtung gemäß Anspruch 1, wobei die Lichtpulsquelle (2, 102) eine Laserlichtquelle ist, um einen Laserlichtpuls auszugeben.

4. Photoelektronenmeßvorrichtung gemäß Anspruch 1, wobei ein Abstand zwischen der Photokathode (41, 141) und der Beschleunigungselektrode kurzgehalten wird.

5. Photoelektronenmeßvorrichtung nach Anspruch 1, wobei ein Potential der Beschleunigungselektrode in Bezug auf ein Potential der Photokathode ausreichend hoch gesetzt wird, um einen Photoelektronenpuls bereitzustellen, der eine Periode aufweist, die im Bereich von Femtosekunden bis Pikosekunden liegt.

6. Photoelektronenmeßvorrichtung nach Anspruch 1, die weiter eine Mikrokanalplatte (48) umfaßt, die den modulierten Photoelektronenpuls verstärkt, bevor er von der Detektionseinrichtung (49) aufgefangen wird.

7. Photoelektronenmeßvorrichtung gemäß Anspruch 1, die weiter eine Dynodenplatte umfaßt, um den modulierten Photoelektronenpuls zu verstärken, bevor er von der Detektionseinrichtung aufgefangen wird.

8. Photoelektronenmeßvorrichtung gemäß Anspruch 1, wobei die Signalelektrode (44, 143) eine Streifenleitungselektrode ist.

9. Photoelektronenmeßvorrichtung gemäß Anspruch 3, die weiter eine Einrichtung umfaßt, um ein detektiertes Signal eines Photoelektronenstroms, der zwischen der elektrooptischen Oberfläche und der Beschleunigungselektrode (43, 142, 146, 47) existiert, zurück zu der Laserlichtquelle zu führen, um so die Laserlichtquelle (2, 102) zu steuern.

10. Photoelektronenmeßvorrichtung gemäß Anspruch 3, weiter umfassend eine Einrichtung zum Triggern der Signalquelle (1, 101), um das zu messende Signal zu erzeugen und zum Triggern der Laserlichtquelle (2, 102) um den Laserlichtpuls auszugeben.

11. Photoelektronenmeßvorrichtung gemäß Anspruch 3, die weiter eine Einrichtung umfaßt, die auf den Laserlichtpuls anspricht, um die Signalquelle (1, 101) zu triggern, um das zu messende Signal zu erzeugen.

12. Photoelektronenmeßvorrichtung gemäß Anspruch 3, die weiter eine Verzögerungsschaltung (10, 11, 32, 130) sowohl für die Lichtquelle (202) als auch für die Signalquelle (1, 101) umfaßt, um die Ausgabe des Laserlichtpulses und des zu messenden Signals je nach Wunsch zu verzögern.

13. Photoelektronenmeßvorrichtung gemäß Anspruch 1, **dadurch gekennzeichnet**, daß die Vorrichtung weiter umfaßt:
eine Verzögerungseinrichtung (10, 111, 32, 124), um eine Verzögerungszeitdifferenz zwischen dem Photoelektronenpuls und dem zu messenden Signal herzustellen,
eine Ablenkeinrichtung (147, 148), um den Photoelektronenpuls entsprechend der Verzögerungszeitdifferenz abzulenken, eine Detektionseinrichtung (49, 150, 151), um eine zweidimensionale Bildinformation darzustellen, die für jede Versetzung des Photoelektronenpulses, bedingt durch die Ablenkung von der Ablenkvorrichtung, erhalten wird, und
eine Bildinformationsverarbeitungseinrichtung, um die zweidimensionale Bildinformation zu verarbeiten und zu analysieren.

14. Photoelektronenmeßvorrichtung gemäß Anspruch 13, die weiter eine thermische Elektronenquelle umfaßt, um den Photoelektronenpuls mit Hilfe einer elektrisch erzeugten Spannung herzustellen.

15. Photoelektronenmeßvorrichtung gemäß Anspruch 13, wobei das zu messende Signal durch Modulieren der Intensität des Photoelektrodenpulses, auf der Basis einer Spannung des zu messenden Signales erfaßt wird.

16. Photoelektronenmeßvorrichtung gemäß Anspruch 13, wobei die Detektionseinrichtung (4, 104) einen Leuchtschirm (150) einschließt, um die zweidimensionale Bildinformation in ein optisches Bild umzuwandeln.

17. Photoelektronenmeßvorrichtung gemäß Anspruch 13, wobei die Detektionseinrichtung (4, 104, 151) eine Halbleiterbildvorrichtung einschließt, um die zweidimensionale Elektronenbildinformation in ein elektrisches Bild umzuwandeln.

18. Photoelektronenmeßvorrichtung gemäß Anspruch 13, die weiter eine erste Ablenkelektrode (148) umfaßt, um den Photoelektronenpuls in eine horizontale Richtung abzulenken und eine zweite Ablenkelektrode (147), um den Photoelektronenpuls in eine vertikale Richtung abzulenken.

19. Photoelektronenmeßvorrichtung gemäß Anspruch 13, die weiter eine erste Ablenkelektrode (147) umfaßt, um den Photoelektronenpuls in eine vertikale Richtung abzulenken und eine zweite Ablenkelektrode (148), um den Photoelektronenpuls in eine horizontale Richtung abzulenken.

20. Photoelektronenmeßvorrichtung gemäß Anspruch 13, die weiter ein elektronisches Tor (105) umfaßt, um Rauschen von der Photokathode zu reduzieren.

21. Photoelektronenmeßvorrichtung gemäß Anspruch 18, wobei die Ablenkspannung, die zumindest an eine, entweder an die horizontale oder die vertikale Ablenkelektrode (147, 148) angelegt wird, entweder einen sinusförmigen, rampenförmigen stufenförmigen, logarithmusförmigen oder exponentialförmigen Spannungswellenverlauf hat.

22. Photoelektronenmeßvorrichtung gemäß Anspruch 15, die weiter eine Einrichtung (149) zur Verstärkung des Photoelektronenpulses in zwei Richtungen, nachdem der Photoelektronenpuls moduliert und abgelenkt worden ist, umfaßt.

23. Photoelektronenmeßvorrichtung gemäß Anspruch 1, die weiter eine Anzeigenvorrichtung umfaßt, um die Zeitdifferenz zwischen dem Photoelektronenpuls und dem zu messenden Signal als Funktion darzustellen.

24. Photoelektronenmeßvorrichtung gemäß Anspruch 1, wobei der Abstand zwischen einer Quelle des zu messenden Signals (1, 101) und der Signalelektrode (143, 44) kurzgehalten wird.

25. Photoelektronenmeßvorrichtung gemäß Anspruch 3, wobei eine optische Faser, mit geringem optischem Verlust und hoher Zeitauflösung verwendet wird, um Licht zwischen der Laserlichtquelle und der Photokathode zu transmittieren.

26. Photoelektronenmeßvorrichtung gemäß Anspruch 1, wobei die Fläche der Photokathode (141, 41) kleingehalten ist.

27. Photoelektronenmeßvorrichtung gemäß Anspruch 1, wobei eine Infrarotlichtquelle als Lichtpulsquelle verwendet wird, um so die Anfangsgeschwindigkeitsenergieverteilung des Photoelektronenpulses schmäler zu machen.

28. Photoelektronenmeßvorrichtung gemäß Anspruch 16, wobei das optische Bild ausgelesen wird um in ein elektrisches Signal umgewandelt zu werden, wobei das elektrische Signal in einer Bildverarbeitungseinrichtung bearbeitet wird.

29. Vorrichtung zum Analysieren und Darstellen eines gemessenen elektrischen Signals gemäß Anspruch 17, wobei das elektrische Signal ausgelesen wird, um in einer Bildverarbeitungseinrichtung verarbeitet zu werden.

## Revendications

1. Appareil d'échantillonnage de photoélectrons, comprenant une source d'impulsions lumineuses (2, 102), une photocathode (41, 141) servant à recevoir une impulsion lumineuse émise par ladite source d'impulsions lumineuses (2, 102), une électrode de polarisation (45) et un moyen de détection (49, 150, 151) servant à recueillir l'impulsion photoélectronique ;
caractérisé par :
une électrode de signal (44, 143) servant à recevoir un signal devant être mesuré et à moduler l'impulsion photoélectronique accélérée à l'aide dudit signal devant être mesuré, et
une électrode d'accélération (43, 142, 146, 47) servant à accélérer une impulsion photoélectronique émise par ladite photocathode (41, 141) après réception de ladite impulsion lumineuse.

2. Appareil d'échantillonnage de photoélectrons selon la revendication 1, où ledit moyen de détection (49, 150, 151) servant à recueillir l'impulsion photoélectronique est une électrode.

3. Appareil d'échantillonnage de photoélectrons selon la revendication 1, où ladite source d'impulsions lumineuses (2, 102) est une source lumineuse laser servant à délivrer une impulsion lumineuse laser.

4. Appareil d'échantillonnage de photoélectrons selon la revendication 1, où la distance entre ladite photocathode (41, 141) et ladite électrode d'accélération est fixée courte.

5. Appareil d'échantillonnage de photoélectrons selon la revendication 1, où le potentiel de ladite électrode d'accélération (43, 142, 146, 47) est fixé à un niveau suffisamment élevé par rapport au potentiel de ladite photocathode (41, 141) de façon qu'on obtienne une impulsion photoélectronique dont la durée appartient à un intervalle s'étendant entre les femtosecondes et les picosecondes.

6. Appareil d'échantillonnage de photoélectrons selon la revendication 1, comprenant en outre une galette de microcanaux (48) multipliant l'impulsion photoélectronique modulée avant son recueil par ledit moyen de détection (49).

7. Appareil d'échantillonnage de photoélectrons selon la revendication 1, comprenant en outre une plaque dynode servant à multiplier l'impulsion photoélectronique modulée avant son recueil par ledit moyen de détection.

8. Appareil d'échantillonnage de photoélectrons selon la revendication 1, où ladite électrode de signal (44, 143) est une électrode de ligne triplaque .

9. Appareil d'échantillonnage de photoélectrons selon la revendication 3, comprenant un moyen servant à renvoyer le signal détecté d'un courant photoélectronique, existant entre ladite surface électro-optique et ladite électrode d'accélération (43, 142, 146, 47), à ladite source lumineuse laser en vue de la commande de ladite source lumineuse laser (2, 102).

10. Appareil d'échantillonnage de photoélectrons selon la revendication 3, comprenant en outre un moyen servant à déclencher ladite source de signal (1, 101) en vue de la production dudit signal devant être mesuré et à déclencher ladite source lumineuse laser (2, 102) en vue de la délivrance de ladite impulsion lumineuse laser.

11. Appareil d'échantillonnage de photoélectrons selon la revendication 3, comprenant en outre un moyen qui répond à ladite impulsion lumineuse laser en déclenchant ladite source de signal (1, 101) en vue de la production dudit signal devant être mesuré.

12. Appareil d'échantillonnage de photoélectrons selon la revendication 3, comprenant en outre un circuit retardateur (10, 111, 32, 130) pour chacune desdites sources que constituent ladite source lumineuse (2, 102) et ladite source de signal (1, 101), afin de retarder la sortie de ladite impulsion lumineuse laser et dudit signal devant être mesuré comme cela est souhaitable.

13. Appareil d'échantillonnage de photoélectrons selon la revendication 1,
caractérisé en ce qu'il comprend en outre :
un moyen retardateur (10, 111, 32, 124) servant à produire une différence temporelle de retard entre ladite impulsion photoélectronique et ledit signal devant être mesuré ;
un moyen de déviation (147, 148) servant à dévier ladite impulsion photoélectronique, en fonction de ladite différence temporelle de retard ;
un moyen de détection (49, 150, 151) servant à afficher l'information d'image bidimensionnelle obtenue pour chaque déplacement de ladite impulsion photoélectronique dû à la déviation par ledit moyen de déviation ; et
un moyen de traitement d'information d'image servant à traiter et à analyser ladite information d'image bidimensionnelle.

14. Appareil d'échantillonnage de photoélectrons selon la revendication 13, comprenant en outre une source d'électrons thermiques servant à produire ladite impulsion photoélectronique à l'aide d'une tension produite électriquement.

15. Appareil d'échantillonnage de photoélectrons selon la revendication 13, où ledit signal devant être mesuré est échantillonné par modulation de l'intensité de ladite impulsion photoélectronique sur la base de la tension dudit signal devant être mesuré.

16. Appareil d'échantillonnage de photoélectrons selon la revendication 13, où ledit moyen de détection (4, 104) comporte un écran de luminophores (150) servant à convertir ladite information d'image bidimensionnelle en une image optique.

17. Appareil d'échantillonnage de photoélectrons selon la revendication 13, où ledit moyen de détection (4, 104, 151) comporte un dispositif de formation d'image à semiconducteur servant à convertir ladite information d'image d'électrons bidimensionnelle en une image électrique.

18. Appareil d'échantillonnage de photoélectrons selon la revendication 13, comprenant en outre une première électrode de déviation (148) servant à dévier ladite impulsion photoélectronique dans la direction verticale et une deuxième électrode de déviation (147) servant à dévier ladite impulsion photoélectronique dans la direction verticale.

19. Appareil d'échantillonnage de photoélectrons selon la revendication 13, comprenant en outre une première électrode de déviation (147) servant à dévier ladite impulsion photoélectronique dans la direction verticale et une deuxième électrode de déviation (148) servant à dévier ladite impulsion photoélectronique dans la direction horizontale.

20. Appareil d'échantillonnage de photoélectrons selon la revendication 13, comprenant en outre une porte électronique (105) servant à diminuer le bruit venant de ladite photocathode.

21. Appareil d'échantillonnage de photoélectrons selon la revendication 18, où ladite tension de déviation qui est appliquée à au moins une desdites électrodes de déviation horizontale et verticale (147, 148) est une tension prise dans le groupe suivant : tension à forme d'onde sinusoïdale, tension à forme d'onde en rampe, tension à forme d'onde en marches d'escalier, tension à forme d'onde logarithmique, et tension à forme d'onde en fonction exponentielle.

22. Appareil d'échantillonnage de photoélectrons selon la revendication 15, comprenant en outre un moyen servant à multiplier (149) ladite impulsion photoélectronique suivant deux dimensions, après que ladite impulsion photoélectronique a été modulée et déviée.

23. Appareil d'échantillonnage de photoélectrons selon la revendication 1, comprenant en outre un moyen d'affichage servant à afficher, sous la forme d'une fonction, la différence de position temporelle entre ladite impulsion photoélectronique et ledit signal devant être mesuré.

24. Appareil d'échantillonnage de photoélectrons selon la revendication 1, où la distance entre une source dudit signal (1, 101) devant être mesuré et ladite électrode de signal (143, 44) est fixée courte.

25. Appareil d'échantillonnage de photoélectrons selon la revendication 3, où on utilise une fibre optique ayant de petites pertes optiques et une réponse temporelle élevée pour transmettre la lumière entre ladite source lumineuse laser et ladite photocathode.

26. Appareil d'échantillonnage de photoélectrons selon la revendication 1, où l'aire de ladite photocathode (141, 41) est réalisée petite.

27. Appareil d'échantillonnage de photoélectrons selon la revendication 1, où une source de lumière infrarouge est utilisée au titre de ladite source d'impulsions lumineuses de façon à rendre plus étroite la distribution d'énergie de vitesse initiale de ladite impulsion photoélectronique.

28. Appareil d'échantillonnage de photoélectrons selon la revendication 16, où ladite image optique est lue de façon à être convertie en un signal électrique, ledit signal électrique étant traité dans un moyen de traitement d'image.

29. Appareil d'analyse et d'affichage de signal électrique échantillonné selon la revendication 17, où ledit signal électrique est lu de façon à être traité dans un moyen de traitement d'image.
